# EUROPEAN PATENT APPLICATION

(11) **EP 2 053 643 A1**
(43) Date of publication of application: **29.04.2009**
(21) Application number: 07791669.0
(22) Date of filing: 31.07.2007
(51) Int. Cl.: H01L 21/316

(54) **FILM-FORMING METHOD AND FILM-FORMING APPARATUS**

(30) Priority: 02.08.2006 JP 2006211091
(71) Applicant: Ulvac, Inc., Chigasaki-shi, Kanagawa 253-8543 (JP)
(72) Inventor: MASUDA, Takeshi, Susono-shi Shizuoka 410-1231 (JP); KAJINUMA, Masahiko, Susono-shi Shizuoka 410-1231 (JP); NISHIOKA, Yutaka, Susono-shi Shizuoka 410-1231 (JP); KIMURA, Isao, Susono-shi Shizuoka 4101231 (JP); KIKUCHI, Shin, Susono-shi Shizuoka 410-1231 (JP); YAMADA, Takakazu, Susono-shi Shizuoka 410-1231 (JP); SUU, Koukou, Susono-shi Shizuoka 410-1231 (JP)
(74) Representative: Eisenführ, Speiser & Partner
(86) International application number: PCT/JP2007/064984
(87) International publication number: WO 2008/016047

(57) **Abstract**

A film forming method in which crystalline film having PZT (001) or PZT (100) as a principal component thereof is laminated on a foundation film having a (111) oriented noble metal as a principal component thereof, the method including the steps of: performing reduction treatment on a surface of the foundation film; and forming the crystalline film by an MOCVD method on the surface of the foundation film.

## Description

### TECHNICAL FIELD

The present invention relates to a film forming method and film forming apparatus.
Priority is claimed on Japanese Patent Application No. 2006-211091, filed August 2, 2006, the contents of which are incorporated herein by reference.

### BACKGROUND ART OF THE INVENTION

Among lead zirconate titanates (Pb (Zr, Ti) O₃; PZT) having a Perovskite structure, those crystalline films having a (001) orientation show a superior piezoelectric effect. Because of this, their use for a piezoelectric film for forming a piezoelectric element is being examined. The use of a metal-organic chemical vapor deposition (MOCVD) process which has superior step coverage is also being examined as a method of manufacturing a piezoelectric film consisting of the (001) orientation PZT (referred to below as PZT (001)). In CVD methods in which a film is formed on a substrate by reacting a thin film raw material at a high temperature, An the MOCVD processMOCVD method is a process in which, in a CVD process in which a film is formed on a substrate by reacting a thin film raw material at a high temperature, particularly employs an organometal is used for the raw material, in particular, and in which a film is formed by causing reacting an organometallic gas and an oxide gas.

However, even if a PZT film is formed on a surface of a lower electrode film (a foundation film) which consists of Ir, Pt, or the like, the PZT (001) or PZT (100) orientation is not preferentially obtained, but there ends up being a random orientation which includes PZT (111), PZT (110), PZT (101) and the like (see, for example, Patent document 1).
Patent document 1: Japanese Unexamined Patent Application, First Publication No. 2003- 324101

### DETAILED DESCRIPTION OF THE INVENTION

### Problems to be solved by the invention

The present invention was conceived in order to solve the above described problem, and it is an object thereof to provide a film forming method and film forming apparatus that make it possible to preferentially obtain the PZT (001) or PZT (100) orientation.

### Means for solving the problem

In order to achieve the above described object, the present invention employs the following. Namely, the present invention employs a film forming method in which crystalline film having PZT (001) or PZT (100) as a principal component thereof is laminated on a foundation film having a (111) oriented noble metal as a principal component thereof, the method including the steps of: performing reduction treatment on a surface of the foundation film; and forming the crystalline film by an MOCVD method on the surface of the foundation film.
According to the above described film forming method, it is possible to preferentially obtain the PZT (001) or PZT (100) orientation.

It may be arranged such that the reduction treatment is performed using a solvent for an organometal which is supplied for the MOCVD method.
In this case, since it is not necessary to introduce new reducing gas, it is possible to lower manufacturing costs.

It may be arranged such that the solvent is tetrahydrofuran.
Tetrahydrofuran is not only preferable as the solvent of an organometal, but it also has superior reducibility. Accordingly, it is possible to preferentially obtain the PZT (001) or PZT (100) orientation.

Furthermore, the present invention employs a film forming apparatus which forms a crystalline film having PZT (001) or PZT (100) as a principal component thereof on a substrate on which a foundation film having a (111) oriented noble metal as a principal component thereof has been formed, the apparatus including: a reduction treatment chamber in which reduction treatment is performed on a surface of the foundation film; a film formation chamber in which the crystalline film is formed on the surface of the foundation film using an MOCVD method; and a substrate transporting chamber through which the substrate is transported from the reduction treatment chamber to the film formation chamber.
According to the above described film forming apparatus, at the same time as reduction treatment is being performed in the reduction treatment chamber, it is possible to perform film formation process in the film formation chamber on a substrate which has already undergone reduction treatment, thereby enabling film formation to be performed efficiently. Moreover, since it is possible to transport substrates sequentially to the reduction treatment chamber and the film formation chamber with the transporting chamber centered, it is possible to improve the manufacturing efficiency. In addition, since the substrate is not exposed to the atmosphere, it is possible to prevent impurities and the like adhering to the substrate.

It may be arranged such that the solvent for an organometal which is supplied for the MOCVD process in the film formation chamber is also used in the reduction treatment step performed in the reduction treatment chamber.
In this case, since it is not necessary to provide a new reducing gas supply device, it is possible to lower manufacturing costs.

### Advantageous effects of the invention

According to the present invention, it is possible to preferentially obtain the PZT (001) or PZT (100) orientation on the surface of a foundation film which consists of a noble metal having a (111) orientation.

### BRIEF DESCRIPTION OF THE DRAWINGS

[FIG. 1] FIG 1 is a cross-sectional view showing the schematic structure of a piezoelectric element.
[FIG 2] FIG 2 is a schematic structural view of a film forming apparatus.
[FIG. 3] FIG. 3 is a schematic structural view showing a variant example of the film forming apparatus.
[FIG. 4] FIG 4 is a graph showing an x-ray diffraction (XRD) intensity when the type of gas flowing over a substrate is varied.

### Description of the reference symbols

- 12: Lower electrode film (foundation film)
- 15: Piezoelectric film (crystalline film)
- 90: Film forming apparatus
- 92: Film formation chamber
- 93: Substrate transporting chamber
- 94: Reduction treatment chamber

### BEST MODE FOR CARRYING OUT THE INVENTION

Embodiments of the present invention will now be described with reference to the drawings. Note that the scale of the respective components in the respective drawings used in the description given below has been appropriately modified in order to make the respective components a recognizable size.
The film forming method according to the present embodiment is used to form a piezoelectric film (i.e., a crystalline film) whose principal component is PZT (001), and the piezoelectric film is preferably used in piezoelectric elements. For this reason, a description of a piezoelectric element will be given first.

### (Piezoelectric elements)

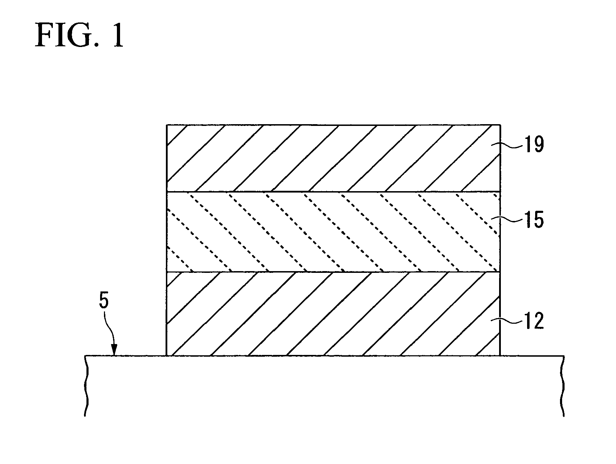

FIG. 1 is a cross-sectional view showing the schematic structure of a piezoelectric element. A lower electrode film (i.e., a foundation film) 12 whose principal component is (111) oriented iridium (referred to as Ir (111)) is formed on a surface of a substrate 5. Note that an adhesive layer consisting of Ti or the like may be formed between the substrate 5 and the lower electrode film 12. In addition, a piezoelectric film 15 is formed on a surface of the lower electrode film 12. The piezoelectric film 15 is formed of lead zirconate titanate (Pb (Zr, Ti) O₃; PZT) having a Perovskite structure, especially PZT having a (001) orientation because of its particularly conspicuous piezoelectric characteristics. An upper electrode film 19 which is consisting of Ir (111) or the like is formed on a top surface of the piezoelectric film 15.

### (Film forming apparatus)

Next, a description will be given of an apparatus to form a piezoelectric film which is used to create a piezoelectric element. This piezoelectric film is formed using a metal-organic chemical vapor deposition (MOCVD) process. In CVD methods in which a film is formed on a substrate by reacting a thin film raw material at a high temperature, the MOCVD method particularly employs an organometal for the raw material, in which a film is formed by reacting an organometallic gas and an oxide gas.

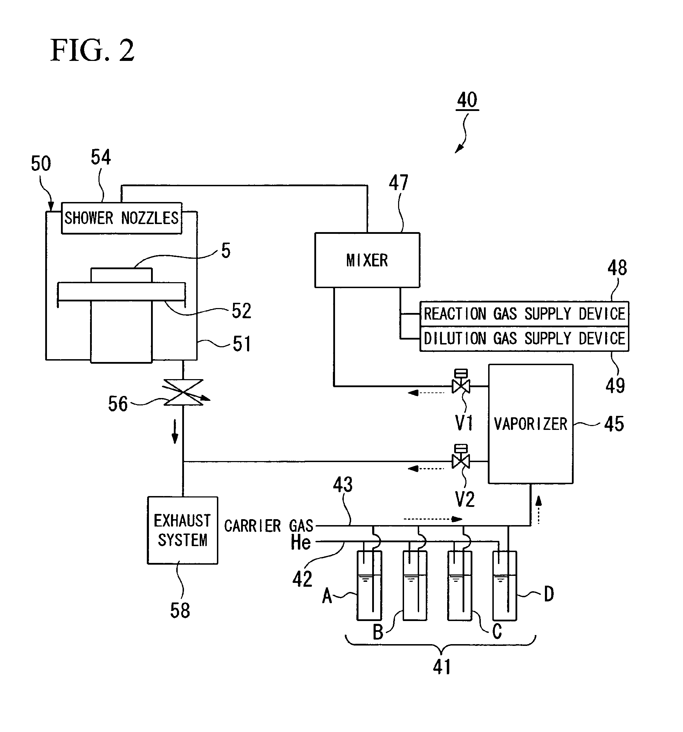

FIG 2 is a schematic structural view of the film forming apparatus. The film forming apparatus 40 is formed by connecting in the following sequence: a raw material supply unit 41 which supplies an organic solvent solution of an organometal; a vaporizer 45 which creates a raw material gas by vaporizing the solution; a mixer 47 which creates a gas mixture of the raw material gas, a reaction gas, and the like; and a film formation chamber 50 where film formation processing is performed by blowing the gas mixture onto the substrate 5.

The raw material supply unit 41 is provided with: tanks A, B, C, and D which are filled with organometallic solution and solvent; a supply pipe 42 which supplies He gas to the respective tanks; and a supply pipe 43 for a carrier gas which transports the organometallic solution and solvents discharged from the respective tanks. When He gas is supplied to a tank from the He gas supply pipe 42, the internal pressure of the tank increases, and the organometallic solution and solvent with which the tank has been filled are discharged to the carrier gas supply pipe 43. Droplets of the discharged organometallic solution and solvent are transported to the vaporizer 45 by a carrier gas such as N₂ gas or the like.

The vaporizer 45 vaporizes the droplets of organometallic solution and solvent by heating them, and thereby creates a raw material gas. For this reason, the vaporizer 45 is provided with a heating device (not shown). Note that it is desirable for the vaporization efficiency to be improved by performing the above described method in combination with a method in which gas or ultrasonic waves or the like are made to strike the droplets of the organometallic solution and solvent, or in combination with a method in which droplets which have been atomized in advance via atomization nozzles are introduced.

The mixer 47 creates a gas mixture made up of the created raw material gas and a reaction gas and/or dilution gas. Because of this, a reaction gas supply device 48 and/or a dilution gas supply device 49 are connected to the mixer 47. The reaction gas supply device 48 supplies an oxidizing gas such as oxygen gas, single reduction treatment dinitrogen gas, ozone gas or the like. The dilution gas supply device 49 supplies nitrogen gas, argon gas or the like.

The film formation chamber 50 introduces the gas mixture containing the raw material gas, and forms a piezoelectric film on the substrate 5. Shower nozzles 54 which eject the gas mixture towards the substrate 5 are provided in the ceiling of a chamber 51 of the film formation chamber 50. A stage 52 on which a substrate 5 is mounted is provided in the interior of the chamber 51. The stage 52 is provided with a heating device such as a heater or the like (not shown), and is able to heat a substrate 5 which has been mounted thereon. The chamber 51 is connected via a pressure adjustment valve 56 to an exhaust system 58 which is provided with a dry pump or a turbo-molecular pump or the like.

Note that it is also possible to supply only a reducing gas obtained by vaporizing only the solvent of the organometal to the film formation chamber 50 without supplying a raw material gas obtained by vaporizing the organometallic solution. The THF (tetrahydrofuran) used as a solvent has reducibility. By supplying only the reducing gas, it is possible to perform reduction treatment on the surface of the lower electrode film prior to the formation of the piezoelectric film. As a result, in the film formation chamber 50, it is possible to continuously perform the surface refining (i.e., reduction) on the lower electrode, and the formation of the piezoelectric film. Moreover, since the reducing gas used in the reduction treatment is the same gas as the solvent gas used in the film formation process, it is possible to reduce manufacturing costs.

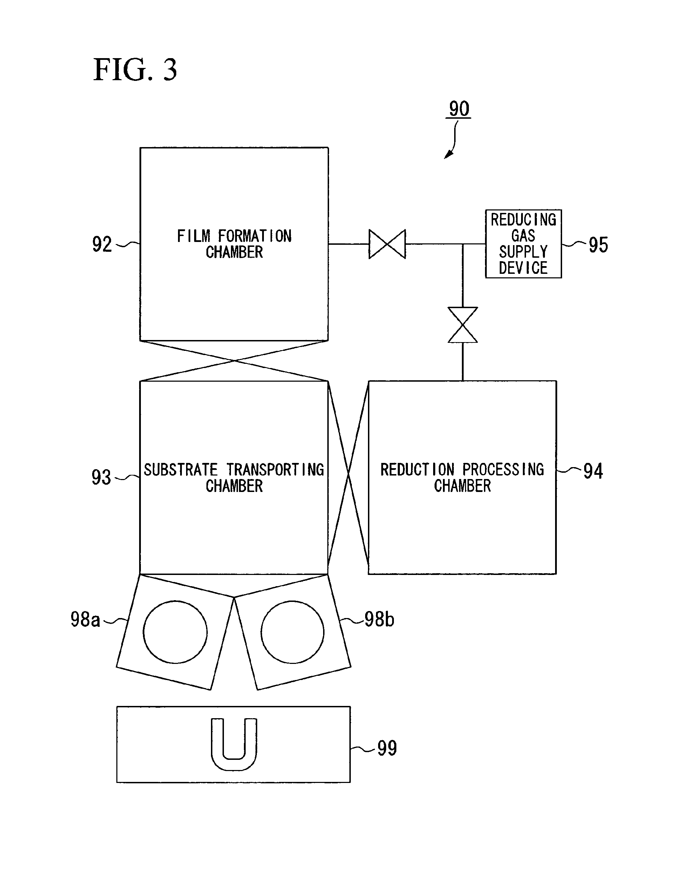

FIG 3 is a schematic structural view showing a variant example of the film forming apparatus. In a film forming apparatus 90 according to the variant example, a reduction treatment chamber 94 is provided in addition to a film formation chamber 92. The reduction treatment chamber 94 has a function of performing reduction treatment on the surface of the lower electrode film prior to the formation of the piezoelectric film thereon. Accordingly, a reducing gas supply device 95 is connected to the reduction treatment chamber 94. Because the reducing gas is also the solvent gas which is used in the film formation processing, the reducing gas supply device 95 is also connected to the film formation chamber 92. In this manner, since the reducing gas supply device 95 can be used by both the reduction treatment chamber 94 and the film formation chamber 92, manufacturing costs can be reduced.

The reduction treatment chamber 94 and the film formation chamber 92 are linked to a substrate transporting chamber 93 via gate valves. A substrate transporting robot (not shown) which transports substrates into and away from the reduction treatment chamber 94 and the film formation chamber 92 is provided in the substrate transporting chamber 93. A plurality of substrate cassettes 98a and 98b are able to be loaded in the substrate transporting chamber 93. By performing processing on a substrate of one of the substrate cassettes and placing the substrates of the other substrate cassette on standby, it is possible to save time and perform processing continuously.

In the film forming apparatus 90, in parallel with the reduction treatment performed in the reduction treatment chamber 94, it is possible to perform film formation processing in the film formation chamber 92 on substrates which have already undergone the reduction treatment, thereby enabling film formation to be performed efficiently. Moreover, since substrates can be sequentially transported between the substrate cassette 98, the reduction treatment chamber 94, and the film formation chamber 92 with the transporting chamber 93 centered, it is possible to improve the manufacturing efficiency. At this time, since the substrate is not exposed to the atmosphere, it is possible to prevent impurities and the like adhering to the substrate.

Note that it is also possible for the reduction treatment chamber 94 to be provided outside the film forming apparatus 90. In this case as well, in parallel with the reduction treatment performed in the external reduction treatment chamber 94, it is possible to perform film formation processing in the internal film formation chamber 92 on substrates which have already undergone the reduction treatment, thereby enabling film formation to be performed efficiently.

### (Film forming method)

Next, a film forming method according to the present embodiment will be described. The film forming method according to the present embodiment has a step in which reduction treatment is performed on a surface of a lower electrode film 12 which has Ir (111) as its principal component; and a step in which a piezoelectric film 15 which has PZT (001) as its principal component is formed by an MOCVD method on the surface of the lower electrode film 12.

Firstly, as is shown in FIG 1, the lower electrode film 12 having Ir (111) as its principal component is formed at a thickness of approximately 70 nm on a surface of the substrate 5. The lower electrode film 12 having Ir (111) as its principal component can be formed, for example, by performing a spattering process while the substrate 5 is being heated to 500°C or more. The lower electrode film 12 having Ir (111) as its principal component can also be formed by performing a spattering process at room temperature so as to create a non-crystalline film of Ir, and by then crystallizing the non-crystalline film by heating it to 500°C or more using a rapid thermal annealing (RTA) apparatus or the like. Note that it is also possible to form a lower electrode film having a noble metal such as (111) oriented Pt or the like as its principal component instead of Ir (111).

Next, refining (i.e., reduction) processing is performed on the surface of the lower electrode film 12. Specifically, a substrate on which the lower electrode film 12 has been formed is mounted on the stage 52 of the film formation chamber 50 shown in FIG 2. Note that the tanks B to D of the raw material supply unit 41 are filled with an organometallic solution, while the tank A is filled only with a solvent thereof.
Therefore, the solvent alone is supplied from the tank A to the vaporizer 45, so that a reducing gas is created. The reducing gas is supplied to the mixer 47, and is then further supplied to the film formation chamber 54. As a result, reducing gas flows for a predetermined time from the shower nozzles 54 of the film formation chamber 50 towards the substrate 5. In this case, the reducing gas density inside the chamber 51 may be set, for example, to approximately 90%, and the pressure inside the chamber 51 is set to 5 Torr or more which is the pressure during film formation. Moreover, the substrate 5 is heated to 500°C or more, and preferably to 600°C or more, and more preferably to 620°C or more using the heating device of the stage 52 while the reducing gas is flowing. By performing the process, the surface of the lower electrode film 12 having Ir (111) as its principal component is made to undergo reduction treatment.

Next, the piezoelectric film 15 having PZT (001) as its principal component is formed by an MOCVD method on the surface of the lower electrode film 12. In CVD methods in which a film is formed on a substrate by reacting a thin film raw material at a high temperature, the MOCVD method particularly employs an organometal for the raw material. An organometal whose raw material is PZT includes at least one of Pb, Zr, and Ti, and it is possible to employ Pb (thd)₂ ((bis (2,2,6,6) tetramethyl (3,5) heptanedionate) lead), Zr (dmhd)₄ ((tetrax (2,6) dimethyl (3,5) heptanedionate) zirconium), Ti (iPrO)₂ (thd)₂ ((bis isopropoxide) (bis (2,2,6,6) tetramethyl (3,5) heptanedionate) titanium), and the like. These organometals are dissolved in an organic solvent such as THF (tetrahydrofuran), so as to create an organometallic solution having a concentration of approximately 0.3 mol/L.

The tanks B through D of the raw material supply unit 41 shown in FIG 2 are filled with the organometallic solution, while only the solvent thereof is placed inside the tank A. Consequently, a raw material gas is created by supplying the organometallic solution and solvent to the vaporizer 45. Next, the raw material gas is supplied to the mixer 47, and a gas mixture is created by mixing the raw material gas with oxygen gas which is an oxide gas (and nitrogen gas which is a dilution gas). The gas mixture is then supplied to the film formation chamber 50, and it is then ejected from the shower nozzles 54 into the interior of the chamber 51. As a result, a piezoelectric film having PZT (001) as its principal component is formed on the surface of the lower electrode film 12 on the substrate 5.

Note that the piezoelectric film may also be made up of a bottom layer film and a top layer film. The bottom layer film is formed so as to have a thickness of approximately 5 nm when the oxygen gas density inside the chamber is set to approximately 8.5%. The top layer film is formed so as to have a thickness of approximately 95 nm when the oxygen gas density inside the chamber is set to approximately 85%. Note that the supply rate of the raw material gas is adjusted such that the composition of the PZT in the bottom layer film and the top layer film satisfies the conditions of Pb / (Zr + Ti) ≒ 1.17 and Zr / (Zr + Ti) ≒ 0.45.

Consideration will now be given to the relationship between the surface refining of the lower electrode film and the orientation intensity of the PZT (001) in the piezoelectric film.

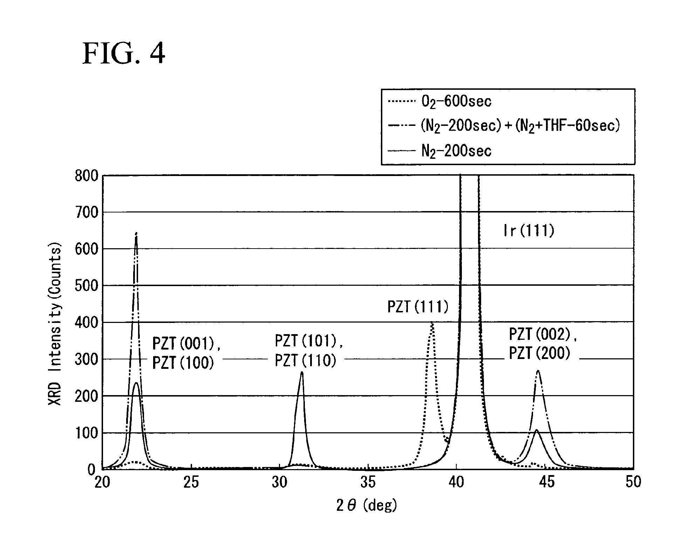

FIG 4 is a graph showing an X-ray diffraction (XRD) intensity when the type of gas flowing over a substrate is varied. As is described above, surface refining processing was performed on the lower electrode film prior to the formation of the piezoelectric film. Specifically, a substrate on which a lower electrode film has been formed was placed on the stage 52 of the film formation chamber 50 shown in FIG. 2, and processing gas was made to flow for a predetermined time towards the substrate 5 from the shower nozzles 54. When nitrogen gas was made to flow as the processing gas for 200 seconds, the surface of the lower electrode film was not refined, but the only result was that a natural oxide film having a thickness of approximately 0.5 nm was formed thereon. In this case, as is shown in FIG 4, it was found that there was a random orientation such as PZT (111), PZT (001), (100), PZT (101), (110), and the like.

In contrast to this, when oxygen gas was made to flow as the processing gas for 600 seconds, the surface of the lower electrode film was oxidized, and an IrO₂ (200) film having a thickness of approximately 5 nm was formed. In this case, as is shown in FIG 4, it was found that there was substantially no orientation to PZT (001), (100), and PZT (101), (110) but the PZT (111) orientation was preferentially obtained.

Conversely, when THF gas was made to flow as the processing gas, the surface of the lower electrode film was reduced. Specifically, firstly nitrogen gas was made to flow for 200 seconds, and nitrogen gas together with THF gas were then made to flow for 60 seconds. As a result, the natural oxide film and the like formed on the surface of the lower electrode film were reduced. In this case, as is shown in FIG 4, it was found that there was substantially no orientation to PZT (111) and PZT (101), (110) but the PZT (001), (100) orientation was preferentially obtained.

As has been described above in detail, the film forming method of the present invention is a method of laminating a layer of piezoelectric film having PZT (001) as its principal component on a lower electrode film having Ir (111) as its principal component, the method including the steps of: performing reduction treatment on a surface of the lower electrode film; and forming the piezoelectric film by an MOCVD method on the surface of the lower electrode film. According to the structure, it is possible to increase the orientation intensity of the PZT (001).

Moreover, since the reduction treatment for the surface of the lower electrode film is performed using an organometallic solvent which is supplied for the MOCVD method, it is not necessary to provide another reducing gas supply device. Accordingly, it is possible to lower manufacturing costs.

Note that the technological range of the present invention is not limited to the above described embodiment, but various modifications may be made to the above described embodiment insofar as they do not depart from the spirit or scope of the present invention. Namely, the specific materials and structure and the like described in the embodiment simply provide an example thereof, and various suitable modifications may be made thereto. For example, in the above embodiment, a description was given of when the orientation intensity of the PZT (001) was increased, however, in the same way, it is also possible to increase the orientation intensity of the PZT (100).

For example, as the organometal which is used for the PZT raw material, in addition to the above described materials it is also possible to use any one of or any combination of Zr (dhd)₄ ((tetrax (2,2,6,6) tetramethyl (3,5) heptanedionate) zirconium), Zr (MMP)₄ ((tetrax (1) methoxy (2) methyl (2) propoxy) zirconium), Ti (MMP)₄ ((tetrax (1) methoxy (2) methyl (2) propoxy) titanium), Zr (iPrO)₂ (thd)₂ ((bis isopropoxide) (bis (2,2,6,6) tetramethyl (3,5) heptanedionate) zirconium), Zr (iPrO) (thd)₃ ((isopropoxide) (tris (2,2,6,6) tetramethyl (3,5) heptanedionate) zirconium), Zr (thd) (dmhd)₃, Zr (thd)₂ (dmhd)₂, and Zr (thd)₃ (dmhd).
As the solvent, in addition to THF (tetrahydrofuran), it is also possible to use any one of or any combination of hexane, cyclohexane, ethylcyclohexane, methylcyclohexane, octane, and butyl acetate.

### INDUSTRIAL APPLICABILITY

It is possible to provide a film forming method and a film forming apparatus in which PZT (001) or PZT (100) orientation is preferentially obtained.

## Claims

1. A film forming method in which crystalline film having PZT (001) or PZT (100) as a principal component thereof is laminated on a foundation film having a (111) oriented noble metal as a principal component thereof, the method comprising the steps of:
performing reduction treatment on a surface of the foundation film; and
forming the crystalline film by an MOCVD method on the surface of the foundation film.

2. The film forming method according to claim 1, wherein the reduction treatment is performed using a solvent for an organometal which is supplied for the MOCVD method.

3. The film forming method according to claim 2, wherein the solvent is tetrahydrofuran.

4. A film forming apparatus which forms a crystalline film having PZT (001) or PZT (100) as a principal component thereof on a substrate on which a foundation film having a (111) oriented noble metal as a principal component thereof has been formed, the apparatus comprising:
a reduction treatment chamber in which reduction treatment is performed on a surface of the foundation film;
a film formation chamber in which the crystalline film is formed on the surface of the foundation film using an MOCVD method; and
a substrate transporting chamber through which the substrate is transported from the reduction treatment chamber to the film formation chamber.

5. The film forming apparatus according to claim 4, wherein the solvent for an organometal which is supplied for the MOCVD process in the film formation chamber is also used in the reduction treatment step performed in the reduction treatment chamber.
